# EUROPÄISCHE PATENTSCHRIFT

(11) **EP 0 470 291 B1**
(45) Veröffentlichungstag und Bekanntmachung des Hinweises auf die Patenterteilung: **05.01.1994**
(21) Anmeldenummer: 90117408.6
(22) Anmeldetag: 10.09.1990
(51) Int. Cl.: G01B 11/00, G01D 5/34

(54) **Optoelektronische Anordnung zum Abtasten von Codeträgern**
Optoelectronic arrangement for the scanning of code carriers
Arrangement optoélectronique pour l'exploration de porteurs de code

(30) Priorität: 09.08.1990 DE 9011628 U
(43) Veröffentlichungstag der Anmeldung: 12.02.1992
(73) Patentinhaber: hohner ELEKTROTECHNIK KG, D-78532 Tuttlingen (DE)
(72) Erfinder: Franz, Heinz-Günther, W-2000 Norderstedt (DE)
(74) Vertreter: Patentanwälte Hauck, Graalfs, Wehnert, Döring, Siemons

(56) Entgegenhaltungen:
- DE-A- 2 839 880
- FR-A- 2 566 896
- FR-A- 2 588 653

## Beschreibung

Gegenstand der Erfindung ist eine optoelektronische Anordnung zum Abtasten von Codeträgern gemäß dem Oberbegriff des Anspruchs 1.

Bei bekannten optoelektronischen Weg-, Winkel- und Rotationsmeßgeräten tastet ein Lichtstrahl die Codespur eines Codeträgers oder Encoders ab und mißt ein Sensor die Intensitätsänderung des Lichtes durch die Codespur. Bei inkrementalen Meßsystemen werden zur Positionsbestimmung lediglich die Intensitätsänderungen gezählt. Bei Stromausfällen kann dies zum Verlust der Lageinformation führen. Absolute Meßsysteme weisen hingegen mehrere Codespuren mit verschiedener Codierung auf, die eine Lagebestimmung allein aufgrund der jeweils ermittelten Codeinformationen ermöglichen.

Bei diesen optischen Meßanordnungen wird meistens ein Durchlichtverfahren angewendet. Hierbei wird ein Lichtstrahl mittels einer Linse kollimiert und durch ein feststehendes Gitter gesandt. Die Codespur des Codeträgers bildet ein entsprechendes Gitter gleicher Teilung, welches in Strahldurchgangsrichtung hinter dem feststehenden Gitter beweglich angeordnet ist. Hinter dem Codeträger befinden sich wiederum geeignete Sensoren, die bei deckungsgleicher Ausrichtung der Gitter Lichtdurchgang und bei versetzter Gitterlage Lichtabdunklung messen. Durch Zählen der Übergänge einer Codespur bzw. durch Messen der Informationen paralleler Codespuren kann die zurückgelegte Strecke ermittelt werden. Das Durchlichtverfahren hat jedoch den Nachteil, daß aufgrund der beiderseitig des Codeträgers angeordneten Komponenten konstruktive und Justageprobleme auftreten. Außerdem verursachen beugungs- und andere optische Effekte eine die exakte Messung beeinträchtigende Aufweitung des durchtretenden Lichtstrahles. Eine hohe Auflösung des Gitters ist deshalb schwer zu erzielen. Bei absoluten Messssystemen mit bis zu 24 Spuren bedingt die Strahlaufweitung einen hohen elektronischen Auswerteaufwand. Schließlich sind die teilweise lichtdurchlässigen Codeträger oder Maßstäbe aus Glas bei manchen Anwendungen, insbesondere in der Werkzeugmaschinentechnik, problematisch.

Bekannte optische Datenspeicher weisen eine Codespur auf, die von derselben Seite bestrahlt und gelesen werden. Hierzu wird das Licht einer Lichtquelle mittels einer Linse auf die Codespur fokussiert und das diffus reflektierte Licht nach Passieren derselben Linse durch einen Strahlteiler ausgekoppelt. Diese Technik ist nur für das Lesen einer Codespur geeignet und hinsichtlich der Fokussierung des Lichtstrahles problematisch.

FR-A1-2566896 zeigt eine optoelektronische Anordnung zum Abtasten von beweglichen Codeträgern gemäß dem Oberbegriff des Anspruchs 1, bei der sowohl für das Kollimieren des einfallenden Lichtes, als auch für das Weiterleiten des durchgestrahlten Lichtes Gradientenindexlinsen vorgesehen sind. Die weiterleitenden Linsen bündeln das Licht aus Flächenbereichen des Codeträgers in optische Fasern hinein, die mit lichtempfindlichen Sensoren verbunden sind. Hierdurch ist die durch das jeweilige Sichtfeld eintretende integrale Lichtmenge bestimmbar, die sich entsprechend der mit der Wegstrecke veränderlichen Lichtdurchlässigkeit des Codeträgers ändert. Eine Abbildung des Codeträgers auf die Sensorfläche ist nicht vorgesehen.

Der Erfindung liegt die Aufgabe zugrunde, die optoelektronische Anordnung der eingangs genannten Art so zu verbessern, daß sie einfacher installierbar ist, einen geringeren Justageaufwand hat und bei hoher Auflösung auch ein vereinfachtes Abtasten mehrerer Codespuren ermöglicht.

Zur Lösung dieser Aufgabe ist erfindungsgemäß bei der eingangs genannten Anordnung vorgesehen, daß die Linse die Codespur in eine lichtempfindliche Sensorfläche optisch abbildet.

Bei einer erfindungsgemäßen Anordnung wird also der Codeträger mit seiner Codespur in der Objektebene auf der einen Seite der stabförmigen Linse positioniert, so daß diese in einer, in die lichtempfindliche Sensorfläche fallende Bildebene auf ihrer anderen Seite eine maßstabsgetreue Abbildung des Bereichs der Codespur in ihrem Sichtfeld erzeugt. Die Lichtquelle zum Ausleuchten der Codespur kann sich sowohl auf der gleichen Seite wie die Linse, als auch auf der gegenüberliegenden Seite des Codeträgers befinden. Im letztgenannten Fall muß der Codeträger durchscheinend sein, wogegen im erstgenannten auch lichtundurchlässige Materialien in Betracht kommen, soweit diese mit einer das reflektierende Licht beeinflussenden Codespur versehen werden können. Dieses öffnet der Erfindung bereits einen erheblich verbreiterten Anwendungsbereich. Außerdem ist vorteilhaft, daß Linse und Sensor auf der gleichen Seite des Codeträgers angeordnet sind, was eine einfache Installation der Anordnung ermöglicht. Die Anordnung auf nur einer Seite des Codeträgers bedingt auch einen geringeren Aufwand für Ausrichtung und Justage. Die Abbildung der Codespur vermeidet Beugungs- und sonstige nachteilige optische Effekte, womit eine hohe Auflösung einhergeht. Dies macht die Anordnung auch für das Abtasten mehrerer, eng zusammenliegender Codespuren besonders geeignet.

Ein Abbild der Codespur in den Sensor mittels üblicher Linsen ist wegen des erheblichen Aufwandes für eine genaue Abbildung nicht praktikabel. Erfindungsgemäß ist eine stabförmige Linse vorgesehen, wie sie schon in Druckern für das Abbilden leuchtender Diodenzeilen in einem Abbildungsmaßstab von 1 : 1 auf den Umfang einer Tonertrommel zum Einsatz gekommen sind. Derartige stabförmige Linsen können einen veränderlichen Brechungsindex haben. Dabei kann es sich um sogenannte "Gradientenindexlinsen" handeln.

Nach einer Ausgestaltung der Erfindung sind mehrere stabförmige Linsen parallel zwischen Codeträger und Sensor angeordnet, wodurch eine Abbildung mehrerer Codespuren in einen Sensor mit lichtempfindlichen Sensorflächen entsprechend den Codespuren begünstigt wird.

Wenn die parallelen Linsen gemäß einer Weiterbildung einander auf dem Codeträger teilweise überlappende Sehfelder haben, wird die Lichtintensität der Abbildung erhöht, weil Überlappungsbereiche in der Objektebene Überlappungsbereichen in der Bildebene entsprechen. Die Abbildungsintensität erhöht sich entsprechend der Anzahl der überlappenden Sehfelder.

Bei einer Fortbildung der Anordnung mit einander überlappenden Sehfeldern der Linsen hat jeweils ein Paar der Linsen eine erste Linse mit einer exzentrischen Einspeisung des Lichtes der Lichtquelle auf der vom Codeträger abgewandten Seite und eine zweite Linse mit einer in entgegengesetzter Richtung exzentrischen Lichtauskopplung in einen Sensor auf der vom Codeträger abgewandten Seite. Das exzentrisch eingespeiste Licht unterliegt in der ersten Linse einer ersten Bildumkehr und wird in den Überlappungsbereich der Sehfelder des Paares projiziert. Das aus dem Überlappungsbereich reflektierte Licht unterliegt in der zweiten Linse einer zweiten Bildumkehr und wird exzentrisch in den Sensor ausgekoppelt. Unmittelbar nebeneinander liegende Linsen können so für die gezielte Lichtein- und Lichtauskopplung genutzt werden. Bei einer Weiterbildung ist zwischen Lichtquelle und Sensor eine Abblendwand angeordnet, die Störeinflüsse auf die Messung verringert.

Schließlich sieht eine Ausgestaltung der Erfindung vor, daß die stabförmigen Linsen zu einem Bündel miteinander verbunden sind. Das Linsenbündel ist einfacher fixierbar und justierbar. Außerdem ermöglichst es eine praktisch unterbrechungsfreie Abbildung auch mehrerer Codespuren in eine Bildebene.

Weitere Einzelheiten des Gegenstandes der Erfindung ergeben sich aus der nachfolgenden Beschreibung der zugehörigen Zeichnung, die drei bevorzugte Ausgestaltungen der optoelektronischen Anordnung zeigt. In der Zeichnung zeigen:
- Fig. 1: eine Anordnung mit einer stabförmigen Linse in perspektivischer Ansicht schräg von oben;
- Fig. 2: eine Anordnung mit zwei stabförmigen Linsen in perspektivischer Ansicht schräg von oben;
- Fig. 3: eine Anordnung mit einem Linsenpaket in perspektivischer Ansicht schräg von oben.

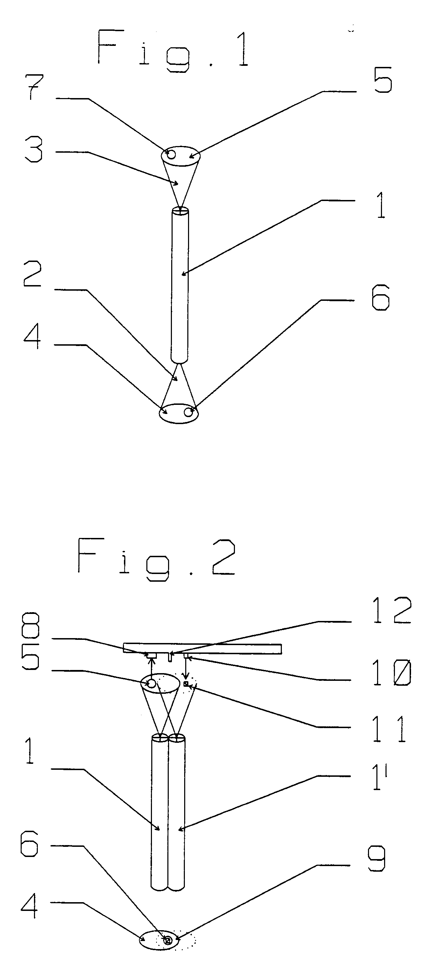

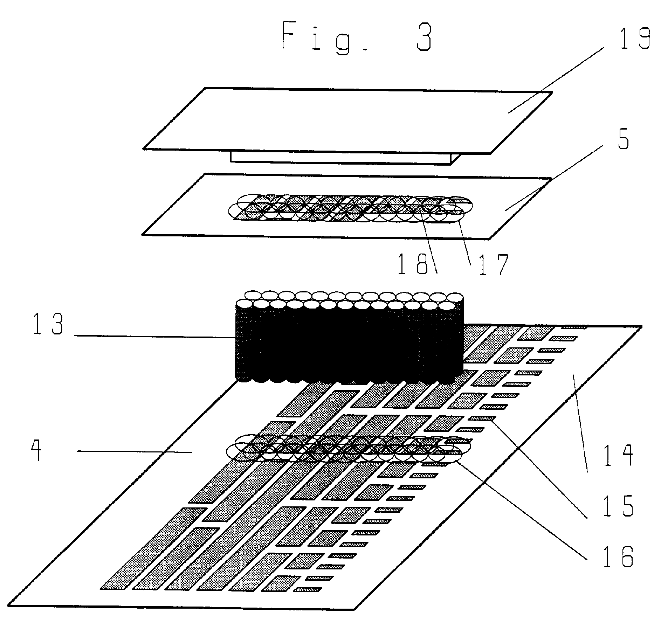

Eine zylinderstabförmige Linse 1 gemäß Fig. 1 hat an beiden Stirnflächen Sehfelder 2, 3, von denen das untere Sehfeld 2 eine Objektebene 4 scharf in eine Bildebene 5 des oberen Sehfeldes 3 abbildet. Ein rechts in der Objektebene 4 befindlicher Punkt 6 wird an der Stelle 7 im Maßstab 1 : 1 in die Bildebene 5 abgebildet, wobei jedoch eine Bildumkehr stattfindet. Das bedeutet, daß sich ein rechts der Mittelachse der Linse 1 in der Objektebene 4 befindlicher Punkt in der Bildebene 5 links abgebildet wird.

Die Bildebene 5 der Anordnung wird auf die Codespur eines - nicht dargestellten - Codeträgers gerichtet, so daß Codeinformationen mittels eines - ebenfalls nicht dargestellten - Sensors gelesen werden können, der sich mit einer lichtempfindlichen Sensorfläche in der Bildebene 5 befindet. Die Beleuchtung erfolgt zweckmäßigerweise von der Linsenseite des Codeträgers aus mittels einer beliebigen Lichtquelle, die in der Fig. 1 ebenfalls nicht abgebildet ist.

Die Fig. 2 zeigt zwei zylinderstabförmige Linsen 1, 1', wovon die erstgenannte in der zuvor beschriebenen Weise mit einer Objektebene 4 auf einen - nicht dargestellten - Codeträger gerichtet ist, wobei ihre Bildebene 5 in eine lichtempfindliche Fläche eines Sensors 8 fällt. Aus Gründen der Übersichtlichkeit ist der Sensor 8 in einem Abstand von der Bildebene 5 gezeichnet.

Die Linse 1' liegt seitlich an der Linse 1 an und ist parallel zu dieser ausgerichtet. Ihr unteres Sehfeld überlappt sich in einem linsenförmigen Überlappungsbereich 9 in der Objektebene 4 mit dem unteren Sehfeld der Linse 1. Das Licht einer Lichtquelle 10 wird exzentrisch in das obere Sehfeld der Linse 1' eingekoppelt.

Durch die Bildumkehr bedingt gelangt ein Lichtpunkt 11 durch die Linse 1' in den Überlappungsbereich 9. Eine weitere Bildumkehr in der Linse 1 bewirkt, daß das Bild 7 des auf dem Codeträger ausgeleuchteten Punktes 6 exzentrisch aus dem unteren Sehfeld der Linse 1 in den fotoelektrischen Sensor 8 ausgekoppelt werden kann. Somit kann eine Codespur gezielt ausgeleuchtet werden, wobei eine Abblendwand 12 zwischen Sensor 8 und Lichtquelle 10 Störeffekte unterdrückt.

Die Fig. 3 zeigt ein Linsenpaket 13 aus Linsen der zuvor beschriebenen Art mit einem Abbildungsmaßstab von 1 : 1, welches über einem Codeträger 14 angeordnet ist, dessen sieben Codespuren 15 mit verschiedenen Codeinformationen eine absolute Längenmessung ermöglichen. Für eine scharfe Abbildung des Objektes ist das Linsenpaket 13 um einen Basisabstand von der Objektebene 4 beabstandet. In der Objektebene 4 überlappen sich die unteren Sehfelder der benachbarten Linsen des Pakets 13 teilweise, wie dies durch kreisförmige Begrenzungslinien 16 versinnbildlicht wird, von denen jede einer Linse zugeordnet ist.

In der oberhalb des Linsenpakets 13 befindlichen Bildebene 5 werden die durch die Umgrenzungslinien 16 umgrenzten Bereiche des Codeträgers 14 abgebildet, was durch Begrenzungslinien 17 verdeutlicht wird. In den linsenförmigen Überlappungsbereich 18 benachbarter Begrenzungslinien 17 ist der Kontrast zwischen hellen und dunklen Bildbereichen besonders groß.

Ein Fotosensor 19 hat an der Unterseite lichtempfindliche Flächen, die in der Bildebene 5 zu positionieren ist, die sich in einem vorbestimmten Abbildungsabstand von dem Linsenpaket 13 befindet. Aus Gründen der Übersichtlichkeit wurde der Fotosensor 19 jedoch in einem Abstand von der Bildebene 5 gezeichnet. Der Sensor 19 kann in seiner lichtempfindlichen Sensorfläche matrixartig verteilte Sensorelemente haben, die eine Zuordnung der empfangenen Lichtsignale zu den Codespuren 15 des Codeträgers 14 ermöglichen.

## Patentansprüche

1. Optoelektronische Anordnung zum Abtasten von Codeträgern, insbesondere für Weg-, Winkel- und Rotationsmeßgeräte sowie optische Datenspeicher, mit mindestens einer Codespur (15) auf dem Codeträger (14), einer auf die Codespur (15) gerichteten Lichtquelle (10), die den Codeträger beleuchtet oder durchleuchtet, einem optoelektronischen Sensor (8, 19), der die Beeinflussung des Lichtes der Lichtquelle durch die Codespur mißt und einer zwischen Codetrager (14) und Sensor (8, 19) angeordneten stabförmigen Linse (1, 1', 13), dadurch gekennzeichnet, daß die Linse (1, 1', 13) die Codespur (15) in eine lichtempfindliche Sensorfläche optisch vorzugsweise maßstäblich abbildet.

2. Anordnung nach Anspruch 1, dadurch gekennzeichnet, daß mehrere stabförmige Linsen (1, 1', 13) parallel zueinander zwischen Codeträger (14) und Sensor (8, 19) angeordnet sind.

3. Anordnung nach Anspruch 2, dadurch gekennzeichnet, daß die parallelen Linsen (1, 1', 13) einander auf dem Codeträger (14) teilweise überlappende Sehfelder (2) haben.

4. Anordnung nach Anspruch 3, dadurch gekennzeichnet, daß jeweils ein Paar der Linsen (1, 1') eine erste Linse (1') mit einer exzentrischen Einspeisung des Lichtes der Lichtquelle (10) auf der vom Codeträger abgewandten Seite und eine zweite Linse (1) mit einer in entgegengesetzter Richtung exzentrischen Lichtauskopplung in einen Sensor (8) auf der vom Codeträger abgewandten Seite hat.

5. Anordnung nach Anspruch 4, dadurch gekennzeichnet, daß eine Abblendwand (12) zwischen Lichtquelle (10) und Sensor (8) angeordnet ist.

6. Anordnung nach einem der Ansprüche 2 bis 5, dadurch gekennzeichnet, daß die stabförmigen Linsen (1, 1', 13) zu einem Bündel miteinander verbunden sind.

## Claims

1. An electro-optical scanner particularly for position-, angle- and rotation-measuring instruments as well as for optical data storages, comprising at least one code track (15) on a code carrier (14), a light source (10) directed to said code track (15) and illuminating or transilluminating said code carrier (14), an electro-optical sensor (8, 19) recording the effects of said code track on the light of said light source, and a rod-shaped lens (1, 1', 13) arranged between said code carrier (14) and said sensor (8, 19), characterized in that said lens (1, 1', 13) forms an image of said code track (15) on the light-sensitive detector area of said sensor, preferably true to scale.

2. The scanner according to claim 1, wherein a plurality of rod-shaped lenses (1, 1', 13) are arranged parallel to each other between said code carrier (14) and said sensor (8, 19).

3. The scanner according to claim 2, wherein said parallel lenses (1, 1', 13) have partly overlapping fields of vision (2) on said code carrier (14).

4. The scanner according to claim 3, wherein each pair of lenses (1, 1', 13) comprises a first lens (1') in which the light of said light source (10) enters eccentrically on the side opposed to said code carrier and a second lens (1) from which the light exits opposed eccentrically into a sensor (8) on the side opposed to said code carrier.

5. The scanner according to claim 4, wherein a screening wall (12) is placed between said light source (10) and said sensor (8).

6. The scanner according to any of the claims 2 to 5, wherein said rod-shaped lenses (1, 1', 13) are interconnected and define a bundle.

## Revendications

1. Dispositif opto-électronique pour la lecture de supports de code, notamment pour des appareils de mesure de déplacements, d'angles et de rotations ainsi que des mémoires optiques de données, comportant au moins une piste de code (15) située sur le support de code (14), une source de lumière (10) dirigée vers la piste de code (15) et qui éclaire le support de code ou l'irradie en transmission, un capteur opto-électronique (18,19), qui mesure l'influence exercée sur la lumière de la source de lumière par la piste de code, et une lentille en forme de barreau (1,1',13) disposée entre le support de code (14) et le capteur (18,19), caractérisé en ce que la lentille (1,1',13) forme optiquement, et de préférence à l'échelle, l'image de la piste de code (15) sur une surface photosensible du capteur.

2. Dispositif selon la revendication (1) caractérisé en ce que plusieurs lentilles en forme de barreau (1,1',13) sont disposées parallèlement les unes aux autres entre le support de code (14) et le capteur (8,19).

3. Dispositif selon la revendication 2, caractérisé en ce que les lentilles parallèles (1,1',13) possèdent des champs d'observation (2) qui se chevauchent partiellement sur le support de code (14).

4. Dispositif selon la revendication 3, caractérisé en ce que chaque fois un couple de lentilles (1,1') comprend une première lentille (1') recevant, sur le côté opposé au support de code, de façon excentrée la lumière de la source de lumière (10), et une seconde lentille (1) réalisant un découplage de lumière, excentré dans la direction opposée, dans un capteur (8) placé du côté opposé au support de code.

5. Dispositif selon la revendication 4, caractérisé en ce qu'une paroi formant écran (12) est disposée entre la source de lumière (10) et le capteur (8).

6. Dispositif selon l'une des revendications 2 à 5, caractérisé en ce que les lentilles en forme de barreaux (1,1',13) sont réunies en un faisceau.
